(19) Europäisches Patentamt / European Patent Office / Office européen des brevets

(11) **EP 4 583 025 A1**

(12) **EUROPEAN PATENT APPLICATION**
published in accordance with Art. 153(4) EPC

(43) Date of publication:
**09.07.2025 Bulletin 2025/28**

(21) Application number: **22957288.8**

(22) Date of filing: **29.08.2022**

(51) International Patent Classification (IPC):
**G06Q 10/0639** *(2023.01)*    **G16Z 99/00** *(2019.01)*

(52) Cooperative Patent Classification (CPC):
**G06Q 10/0639; G16Z 99/00**

(86) International application number:
**PCT/JP2022/032329**

(87) International publication number:
**WO 2024/047682 (07.03.2024 Gazette 2024/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **FUJITSU LIMITED**
**Kawasaki-shi, Kanagawa 211-8588 (JP)**

(72) Inventors:
• **ITANI, Norihiko**
  **Kawasaki-shi, Kanagawa 211-8588 (JP)**
• **YAMAZAKI, Takashi**
  **Kawasaki-shi, Kanagawa 211-8588 (JP)**

(74) Representative: **Hoffmann Eitle**
**Patent- und Rechtsanwälte PartmbB**
**Arabellastraße 30**
**81925 München (DE)**

(54) **COMPUTATION PROGRAM, COMPUTATION METHOD, AND INFORMATION PROCESSING DEVICE**

(57) An arithmetic program causes processing to be executed including: calculating single-objective optimal solutions that have better values than initial solutions by executing single-objective optimization by using each of a plurality of objective functions as a first evaluation function for the initial solutions; and executing, by using the single-objective optimal solutions as starting points, multiobjective optimization for a second evaluation function by using, as the second evaluation function, a linear weighted sum obtained by performing weighting for each of the plurality of objective functions according to the single-objective optimal solutions.

FIG. 6A

FIG. 6B

EP 4 583 025 A1

**Description**

TECHNICAL FIELD

The present case relates to an arithmetic program, an arithmetic method, and an information processing device.

BACKGROUND ART

A technique is disclosed for optimizing a plurality of objective functions such as a production cost or a production completion time when an input order of products to a production line is optimized (for example, refer to Patent Documents 1 to 4).

CITATION LIST

PATENT DOCUMENT

Patent Document 1: Japanese Laid-open Patent Publication No. 2022-83200
Patent Document 2: Japanese Laid-open Patent Publication No. 2002-366587
Patent Document 3: US Patent Publication No. 2015/0019173
Patent Document 4: US Patent Publication No. 2016/0306899

SUMMARY OF INVENTION

TECHNICAL PROBLEM

However, in a case where multi-objective optimization with a plurality of objective functions set is performed, a solution space widens. Therefore, it involves a long time to start a search from an initial input order as an initial solution and calculate a Pareto optimal solution set that contains candidates for an optimal solution.
In one aspect, an object of the present invention is to provide an information processing device, an arithmetic method, and an arithmetic program that may shorten a calculation time.

SOLUTION TO PROBLEM

In one aspect, an arithmetic program causes processing to be executed including: calculating single-objective optimal solutions that have better values than an initial solution by executing single-objective optimization by using each of a plurality of objective functions as a first evaluation function for the initial solution; and executing, by using the single-objective optimal solutions as starting points, multi-objective optimization for a second evaluation function by using, as the second evaluation function, a linear weighted sum obtained by performing weighting for each of the plurality of objective functions according to the single-objective optimal solutions.

ADVANTAGEOUS EFFECTS OF INVENTION

A calculation time may be shortened.

BRIEF DESCRIPTION OF DRAWINGS

FIG. 1 is a diagram exemplifying Pareto solutions.
FIG. 2 is a diagram exemplifying a case where a genetic algorithm is used for a multi-objective optimization engine.
FIG. 3 is a diagram exemplifying a linear weighted sum method.
FIG. 4(a) is a functional block diagram representing an overall configuration of an information processing device according to a first embodiment, and FIG. 4(b) is a hardware configuration diagram of the information processing device.
FIG. 5 is a diagram exemplifying a flowchart of the first embodiment.
FIGs. 6(a) and 6(b) are explanatory diagrams of the first embodiment.

FIG. 7 is a diagram exemplifying a flowchart of a second embodiment.

FIGs. 8(a) and 8(b) are explanatory diagrams of the second embodiment.

FIG. 9 is a diagram illustrating calculation results.

FIG. 10 is a diagram illustrating calculation results.

FIG. 11 is a diagram for describing a hypervolume.

FIG. 12 is a diagram exemplifying a production line model.

FIGs. 13(a) to 13(c) are diagrams exemplifying product information.

FIG. 14 is a diagram illustrating calculation results.

FIG. 15 is a diagram illustrating calculation results.

## DESCRIPTION OF EMBODIMENTS

There are optimization problems in fields of various industries including a manufacturing industry and a distribution industry. For example, in an optimization problem of a production plan at a manufacturing field, there is a problem that a relationship between a manufacturing time needed for a certain production plan and a cost generated in proportion to an operation time of a device becomes a trade-off. For example, there is a problem of a trade-off that, when the manufacturing time is shortened, an operation time of a legacy device having a high operating cost is increased and a cost is increased, and the like.

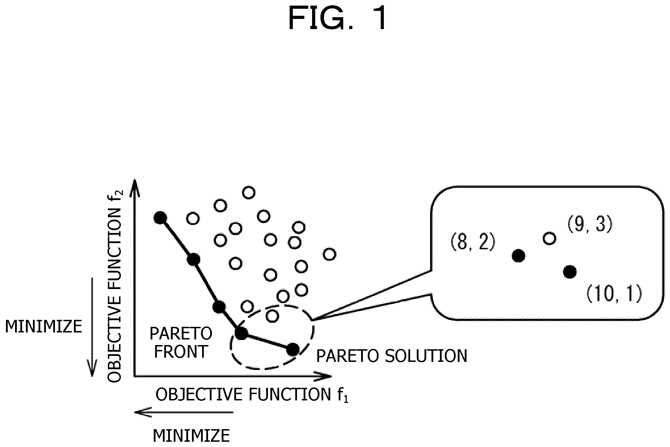

A multi-objective optimization problem for simultaneously optimizing a plurality of objective functions having a trade-off relationship is generally a problem of obtaining a Pareto solution. In the example described above, each of the manufacturing time needed for the certain production plan and the cost generated in proportion to the operation time of the device is the objective function. An explanatory variable is the production plan, and is, for example, an input order in which each product is input to a production process, or the like. The Pareto solution is a solution in which at least one of the plurality of objective functions is superior to those of other optional solutions. FIG. 1 is a diagram exemplifying the Pareto solutions. In FIG. 1, a solution of $(f_1, f_2) = (9, 3)$ is not the Pareto solution since there is no superior objective function when compared with $(f_1, f_2) = (8, 2)$.

In the example of FIG. 1, since optimization is performed so that each objective function is minimized, Pareto solutions positioned on a lower left side are obtained. A line coupling the respective Pareto solutions (arrangement of the respective Pareto solutions) is referred to as a Pareto front. A user selects an optimal solution suitable for a purpose from among the Pareto solutions obtained by multi-objective optimization calculation. Therefore, in order to give a large number of more optimal options to the user, in the multi-objective optimization calculation, it is needed to calculate a more optimal and wider Pareto front in as short a calculation time as possible.

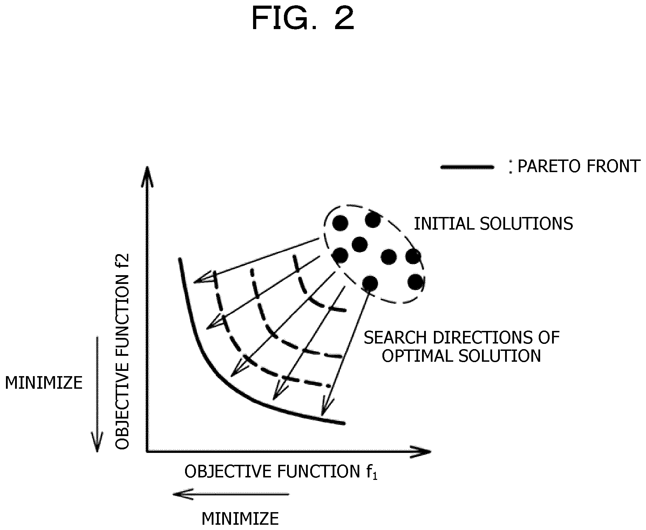

For example, a case is conceivable where a plurality of objective functions desired to be optimized is set to an evaluation function of a multi-objective optimization engine and the multi-objective optimization calculation is performed. FIG. 2 is a diagram exemplifying a case where a genetic algorithm is used as an example for the multi-objective optimization engine. The genetic algorithm is a method of obtaining a solution such that each objective function is minimized from an initial solution group by incorporating genetic elements. In the example of FIG. 2, directions such as moving from initial solutions to a left side and a lower side correspond to search directions. In such a method, it is often not possible to calculate an exact solution in a real time in a real problem having a large problem scale, and thus, it is needed to calculate a more optimal solution in a finite calculation time.

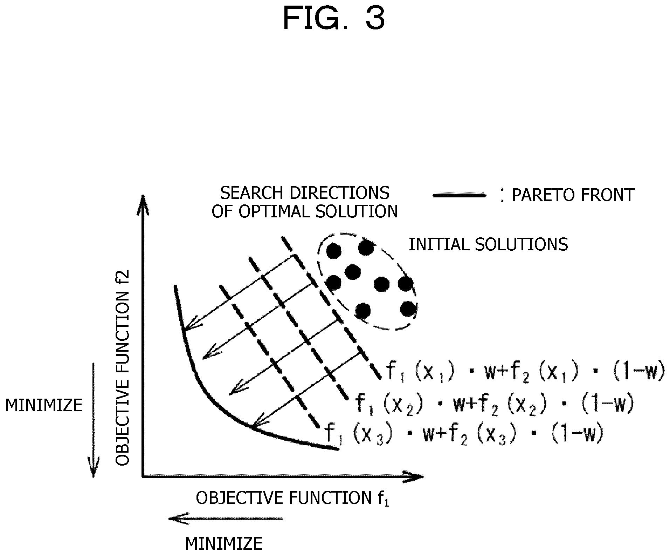

Therefore, a case is conceivable where the plurality of objective functions desired to be optimized is weighted, one evaluation function is set, and optimization calculation is performed with a single-objective optimization engine. FIG. 3 is a diagram exemplifying a linear weighted sum method in this case. For example, an objective function $f_1(x_1) \cdot w +$ an objective function $f_2(x_1) \cdot (1 - w)$ is obtained from the initial solution group, an objective function $f_1(x_2) \cdot w +$ an objective function $f_2(x_2) \cdot (1 - w)$ is obtained from the solutions, and an objective function $f_1(x_3) \cdot w +$ an objective function $f_2(x_3) \cdot (1 - w)$ is further obtained. The reference "w" corresponds to a weight, and is a value that satisfies $0 < w < 1$. However, in such a method, it is difficult to obtain an appropriate weight for a plurality of indexes having different scales as the evaluation function. Furthermore, it is difficult to shorten a calculation time.

Therefore, in the following embodiments, an information processing device, an arithmetic method, and an arithmetic program that may shorten the calculation time will be described.

[First Embodiment]

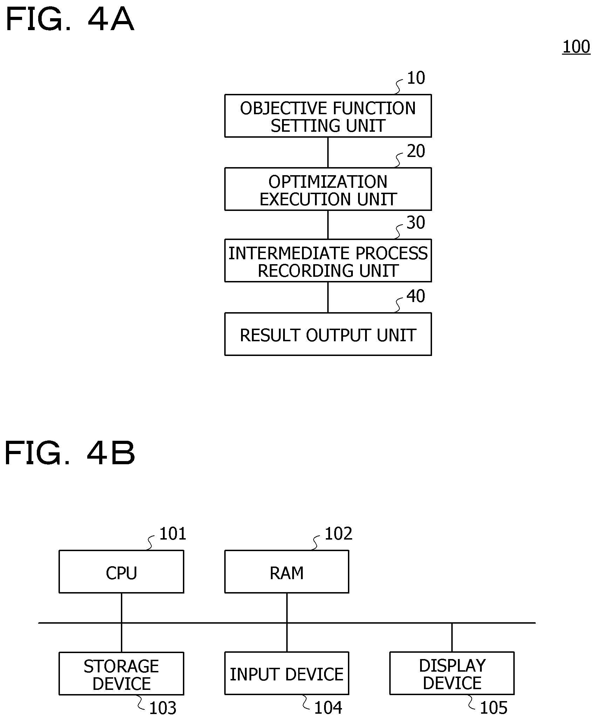

FIG. 4(a) is a functional block diagram representing an overall configuration of an information processing device 100 according to a first embodiment. The information processing device 100 is a server for optimization processing, or the like. As exemplified in FIG. 4(a), the information processing device 100 functions as an objective function setting unit 10, an optimization execution unit 20, an intermediate process recording unit 30, a result output unit 40, and the like.

FIG. 4(b) is a hardware configuration diagram of the information processing device 100. As exemplified in FIG.

4(b), the information processing device 100 includes a CPU 101, a RAM 102, a storage device 103, an input device 104, a display device 105, and the like.

The central processing unit (CPU) 101 is a central processing unit. The CPU 101 includes one or more cores. The random access memory (RAM) 102 is a volatile memory that temporarily stores a program to be executed by the CPU 101, data to be processed by the CPU 101, and the like. The storage device 103 is a nonvolatile storage device. As the storage device 103, for example, a read only memory (ROM), a solid state drive (SSD) such as a flash memory, a hard disk to be driven by a hard disk drive, or the like may be used. The storage device 103 stores an arithmetic program. The input device 104 is a device for a user to input needed information, and is a keyboard, a mouse, or the like. The display device 105 is a device that displays, on a screen, a result output from the result output unit 40, or the like. Each unit of the information processing device 100 is implemented by the CPU 101 executing the arithmetic program. Note that hardware such as a dedicated circuit may be used as each unit of the information processing device 100.

The objective function setting unit 10 sets a plurality of objective functions. The objective function setting unit 10 may set two objective functions or may set three or more objective functions. In the present embodiment, the objective function setting unit 10 sets N objective functions $f_1$ to $f_N$. The optimization execution unit 20 executes optimization such that the objective functions $f_1$ to $f_N$ are optimized. The intermediate process recording unit 30 records a result in the middle of the execution of the optimization by the optimization execution unit 20. The result output unit 40 outputs the result of the optimization executed by the optimization execution unit 20.

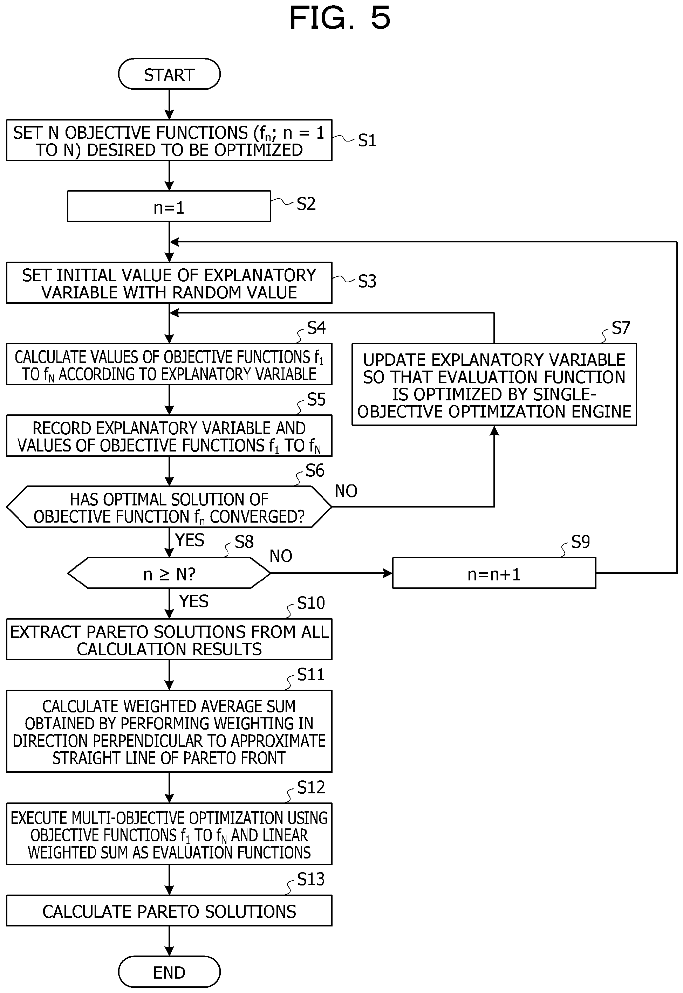

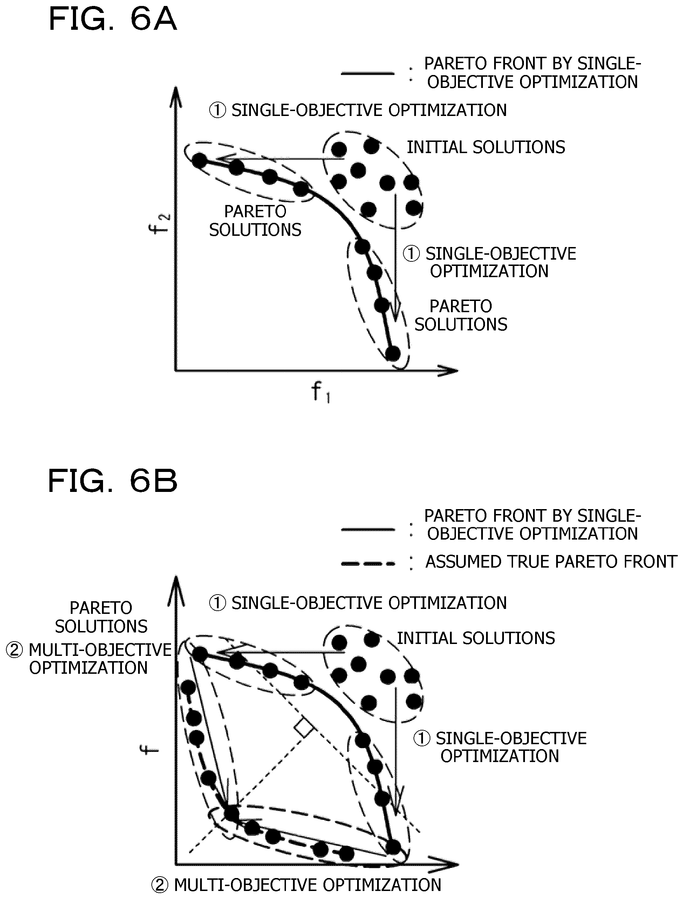

Hereinafter, Pareto optimal solution calculation processing will be described with reference to a flowchart of FIG. 5 and explanatory diagrams of FIGs. 6(a) and 6(b). Note that FIGs. 6(a) and 6(b) are explanatory diagrams for the two objective functions $f_1$ and $f_2$.

First, the objective function setting unit 10 sets the N objective functions ($f_n$; n = 1 to N) desired to be optimized (step S1). Each objective function is, for example, a production completion time in a production process, a cost related to production, or the like. A shorter production completion time is better, and a lower cost is better.

Next, the optimization execution unit 20 sets n to 1 (step S2). As a result, first, the objective function $f_1$ is focused.

Next, the optimization execution unit 20 sets an initial value of each explanatory variable with a random value (step S3). The number of initial values may be one or plural. The initial value may be input by a user using the input device 104.

Next, the optimization execution unit 20 calculates values of the objective functions $f_1$ to $f_N$ according to the explanatory variable (step S4). In a case where step S4 is executed for the first time, the values of the objective functions $f_1$ to $f_N$ are calculated from the initial value of the explanatory variable. In a case where there is a plurality of the initial values, an initial solution group as exemplified in FIG. 6(a) is generated.

Next, the intermediate process recording unit 30 records the explanatory variable used in step S4 and the values of the objective functions $f_1$ to $f_N$ calculated in step S4 (step S5). Therefore, the intermediate process recording unit 30 records the initial solution group.

Next, the optimization execution unit 20 determines whether or not an optimal solution of the objective function $f_n$ has converged (step S6). Here, it is determined whether or not the objective function $f_n$ has reached the best value. Note that it may be determined whether or not a solution better than the initial value has been obtained.

In a case where it is determined as "No" in step S6, the optimization execution unit 20 updates the explanatory variable so that an evaluation function is optimized by a single-objective optimization engine (step S7). Thereafter, step S4 and the subsequent steps are executed again.

In a case where it is determined as "Yes" in step S6, the optimization execution unit 20 determines whether or not n is N or more (step S8). By execution of step S8, it may be determined whether or not single-objective optimization has been ended for all the objective functions.

In a case where it is determined as "No" in step S8, the optimization execution unit 20 adds 1 to n to obtain n + 1 (step S9). Thereafter, step S3 and the subsequent steps are executed again.

In a case where it is determined as "Yes" in step S8, the optimization execution unit 20 extracts Pareto solutions from all calculation results (step S10). As a result, as exemplified in FIG. 6(a), it is possible to extract Pareto solutions obtained by performing the single-objective optimization on each objective function. Note that the extracted Pareto solutions are recorded by the intermediate process recording unit 30.

Next, the optimization execution unit 20 calculates a linear weighted sum obtained by performing weighting according to arrangement of the Pareto solutions extracted in step S10 (step S11). For example, the weighting is performed in a direction perpendicular to an approximate plane approximating the arrangement of the Pareto solutions. When there are two objective functions, an approximate straight line of the Pareto solutions is used instead of the approximate plane described above. In FIG. 6(a), the approximate straight line approximating the Pareto solutions is obtained. An approximation method is not particularly limited, but is, for example, a least squares method or the like. In FIG. 6(b), the approximate straight line and a direction intersecting (for example, a direction perpendicular to) the approximate straight line are drawn. This direction corresponds to a search direction of a solution.

Next, the optimization execution unit 20 executes multi-objective optimization using the objective functions $f_1$ to

$f_N$ and the linear weighted sum as the evaluation functions (step S12). The initial value of the explanatory variable in this case is the explanatory variable corresponding to the Pareto solutions extracted in step S10.

Next, the optimization execution unit 20 calculates Pareto solutions by using an execution result of step S12 (step S13). The Pareto solutions are drawn in FIG. 6(b). Calculation results of step S13 are output by the result output unit 40.

As described above, each of the plurality of N objective functions $f_n(x)$ (n = 1, ..., N) desired to be optimized is set as the evaluation function of the single-objective optimization, and the optimization is performed by the single-objective optimization engine, and each optimal solution of the single-objective optimization and an explanatory variable thereof are solved. Using each optimal solution of the single-objective optimization as a starting point, the linear weighted sum obtained by weighting each objective function in the direction perpendicular to the Pareto front is set as the evaluation function, and the multi-objective optimization calculation is executed to solve the Pareto solutions. The search direction of the optimal solutions is set with the linear weighted sum while minimizing each objective function to solve the true Pareto front.

In this method, the single-objective optimization is performed on each objective function before the multiobjective optimization. Since the multi-objective optimization is performed using the optimal solutions obtained by the single-objective optimization as the starting points, a calculation time until reaching the true Pareto front is shortened. Note that, since a calculation load of the single-objective optimization is significantly smaller than that of the multi-objective optimization, the calculation load is reduced as a result as compared with a case where the multi-objective optimization is performed without performing the single-objective optimization, and the calculation time may be shortened.

[Second Embodiment]

In the first embodiment, a result of an optimal calculation process is used in the single-objective optimization, but the present invention is not limited to this. In a second embodiment, a case will be described where a result of an optimal calculation process is not used in single-objective optimization.

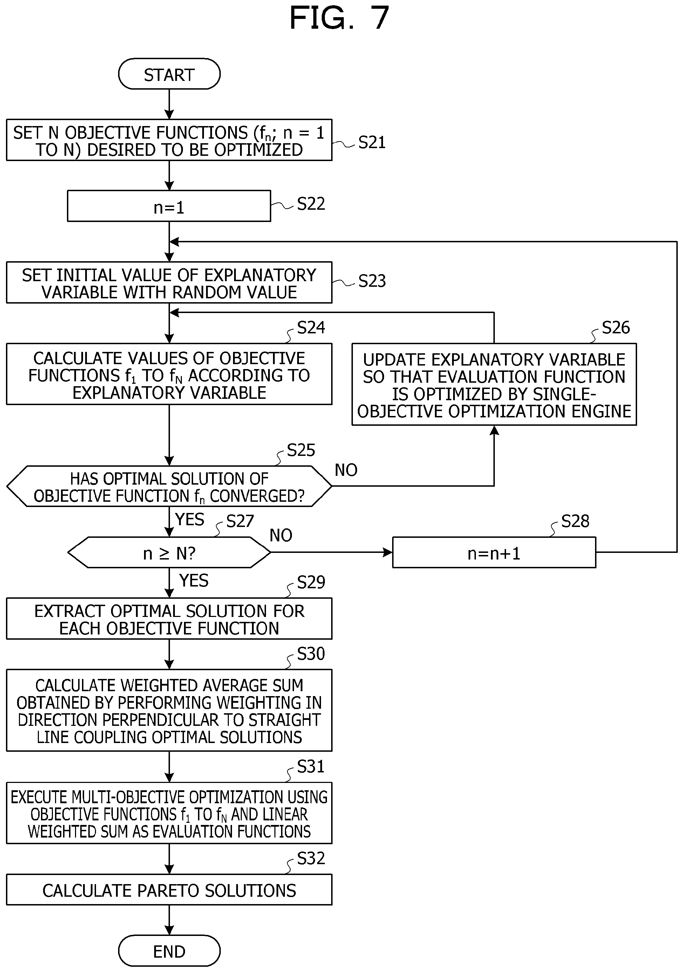

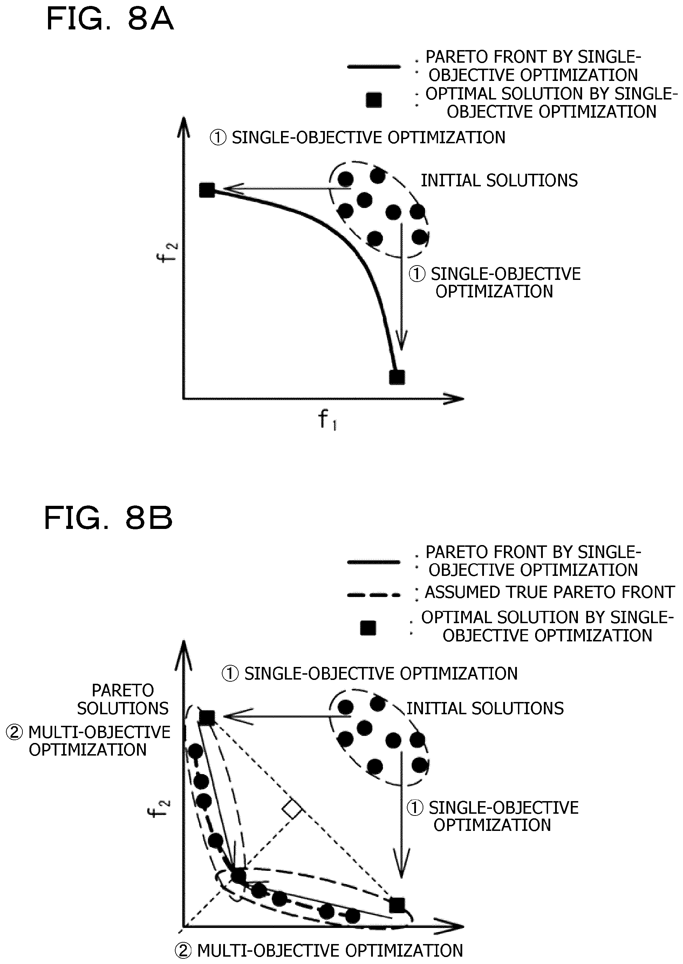

Hereinafter, Pareto optimal solution calculation processing according to the second embodiment will be described with reference to a flowchart of FIG. 7 and explanatory diagrams of FIGs. 8(a) and 8(b). Note that FIGs. 8(a) and 8(b) are explanatory diagrams for two objective functions $f_1$ and $f_2$.

First, the objective function setting unit 10 sets N objective functions ($f_n$; n = 1 to N) desired to be optimized (step S21). Each objective function is, for example, a production completion time in a production process, a cost related to production, or the like. A shorter production completion time is better, and a lower cost is better.

Next, the optimization execution unit 20 sets n to 1 (step S22). As a result, first, the objective function $f_1$ is focused.

Next, the optimization execution unit 20 sets an initial value of an explanatory variable with a random value (step S23). The number of initial values may be one or plural. The initial value may be input by a user using the input device 104.

Next, the optimization execution unit 20 calculates values of the objective functions $f_1$ to $f_N$ according to the explanatory variable (step S24). In a case where step S24 is executed for the first time, the values of the objective functions $f_1$ to $f_N$ are calculated from the initial value of the explanatory variable. In a case where there is a plurality of the initial values, an initial solution group as exemplified in FIG. 8(a) is generated.

Next, the optimization execution unit 20 determines whether or not an optimal solution of the objective function $f_n$ has converged (step S25). Here, it is determined whether or not the objective function $f_n$ has reached the best value. Note that it may be determined whether or not a solution better than the initial value has been obtained.

In a case where it is determined as "No" in step S25, the optimization execution unit 20 updates the explanatory variable so that an evaluation function is optimized by a single-objective optimization engine (step S26). Thereafter, step S24 and the subsequent steps are executed again.

In a case where it is determined as "Yes" in step S26, the optimization execution unit 20 determines whether or not n is N or more (step S27). By execution of step S27, it may be determined whether or not the single-objective optimization has been ended for all the objective functions.

In a case where it is determined as "No" in step S27, the optimization execution unit 20 adds 1 to n to obtain n + 1 (step S28). Thereafter, step S23 and the subsequent steps are executed again.

In a case where it is determined as "Yes" in step S27, the optimization execution unit 20 extracts an optimal solution for each objective function (step S29). As exemplified in FIG. 8(a), a solution having the lowest value of $f_1$ and a solution having the lowest value of $f_2$ are extracted as the optimal solutions. Note that each of the extracted optimal solutions is recorded by the intermediate process recording unit 30.

Next, the optimization execution unit 20 calculates a linear addition sum obtained by performing weighting according to arrangement of the optimal solutions extracted in step S29 (step S30). For example, the weighting is performed in a direction perpendicular to a surface coupling the optimal solutions. When there are two objective functions, a straight line coupling the optimal solutions is used. In FIG. 8(a), the straight line coupling the optimal solutions is obtained. In FIG. 8(b), the line coupling the optimal solutions and a direction intersecting (for example, a direction perpendicular to) the line are drawn. This direction corresponds to a search direction of a solution.

Next, the optimization execution unit 20 executes multi-objective optimization using the objective functions $f_1$ to $f_N$ and the linear weighted sum as the evaluation functions (step S31). The initial value of the explanatory variable in this case is an explanatory variable corresponding to the optimal solutions extracted in step S29.

Next, the optimization execution unit 20 calculates Pareto solutions by using an execution result of step S31 (step S32). The Pareto solutions are drawn in FIG. 8(b). Calculation results of step S32 are output by the result output unit 40.

As described above, each of the plurality of N objective functions $f_n(x)$ (n = 1, ..., N) desired to be optimized is set as the evaluation function of the single-objective optimization, and the optimization is performed by the single-objective optimization engine, and each optimal solution of the single-objective optimization and an explanatory variable thereof are solved. Using each optimal solution of the single-objective optimization as a starting point, each objective function $f_n$ and the linear weighted sum obtained by weighting each objective function in the direction perpendicular to a Pareto front are set as the evaluation functions, and the multi-objective optimization calculation is executed to solve the Pareto solutions. The search direction of the optimal solutions is set with the linear weighted sum while minimizing each objective function to solve the true Pareto front.

In this method, the single-objective optimization is performed on each objective function before the multiobjective optimization. Since the multi-objective optimization is performed using the optimal solutions obtained by the single-objective optimization as the starting points, a calculation time until reaching the true Pareto front is shortened. Note that, since a calculation load of the single-objective optimization is significantly smaller than that of the multi-objective optimization, the calculation load is reduced as a result as compared with a case where the multi-objective optimization is performed without performing the single-objective optimization, and the calculation time may be shortened.

(Simulation Results of First Embodiment)

Hereinafter, simulation results for the first embodiment will be described. As the objective functions, $f_1$ and $f_2$ are used. The multi-objective optimization was performed to minimize these objective functions. As an example, a standard problem of the following expression was used. This standard problem is disclosed in "Eckart Zitzler, Kalyanmoy Ded, and Lothar Thiele, Comparison of Multiobjective Evolutionary Algorithms: Empirical Results, Evolutionary Computation, vol. 8, Issue 2, pp. 173?195 (2000).".

[Expression 1]

$$\mathcal{T}(\mathbf{x}) = (f_1(x_1), f_2(\mathbf{x}))$$

The following expressions are used as examples of the objective function $f_1$ and the objective function $f_2$.

[Expression 2]

$$f_1(x_1) = x_1$$

[Expression 3]

$$f_2(\mathbf{x}) = g(x_2, \cdots, x_m)\left[1 - \sqrt{x_1/g(x_2, \cdots, x_m)}\right]$$

Here, $g(x_2, ..., x_m)$ may be represented as the following expression.

[Expression 4]

$$g(x_2, \cdots, x_m) = 1 + 9 \left( \sum_{i=2}^{m} x_i \right) / (m-1)$$

Note that it is assumed that m = 30 holds and the following expression holds.

[Expression 5]

$$x_i \in [0,1]$$

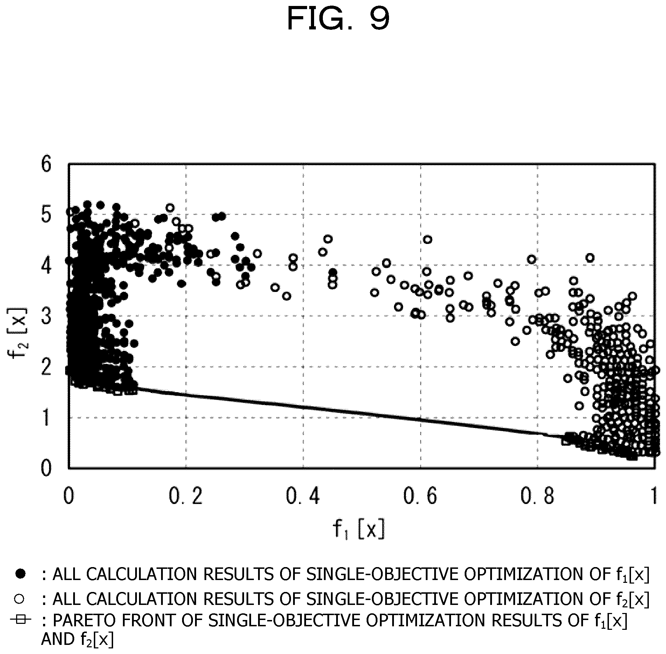

The single-objective optimization was performed for each of the objective functions described above. An explanatory variable x = ($x_1$, $x_2$, ..., $x_{30}$) with an initial value set with a random value was updated by the single-objective optimization engine to minimize the objective functions. In each single-objective optimization, results of a calculation process (values of the explanatory variable x and $f_1(x)$ and $f_2(x)$) were also output. Pareto solutions and explanatory variables thereof were obtained from all calculation results including the results of the calculation process of the single-objective optimization. FIG. 9 is a diagram illustrating the calculation results. As illustrated in the results of FIG. 9, in the single-objective optimization, the results are concentrated in a region where the value of $f_1(x)$ is small and a region where the value of $f_2(x)$ is small.

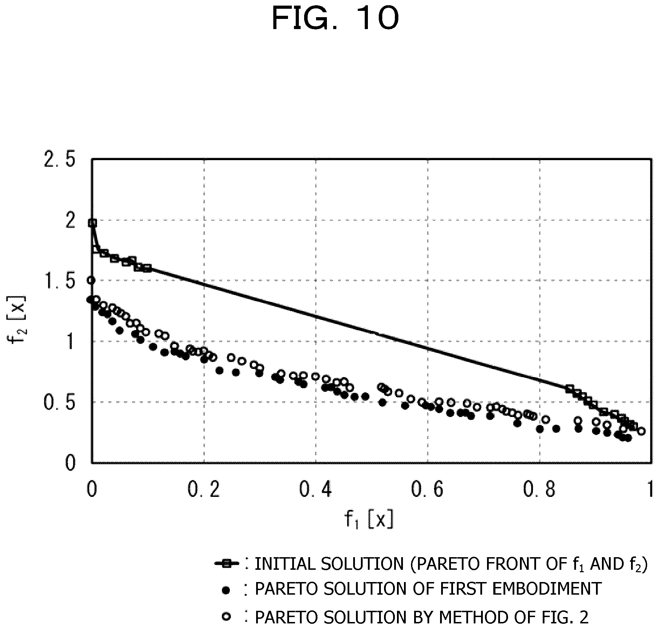

Next, using the Pareto solutions of $f_1(x)$ and $f_2(x)$ as starting points, the multi-objective optimization was performed with three objective functions including a linear weighted sum weighted in a direction perpendicular to an approximate straight line of a Pareto front, $f_1(x)$, and $f_2(x)$. Results are indicated in FIG. 10. In FIG. 10, the Pareto solutions obtained by the method of FIG. 2 are also indicated. When the method of FIG. 2 and the method according to the first embodiment are compared with each other at the same number of times of calculation (about 4900 times), it may be seen that a more optimal Pareto front was able to be calculated by the method according to the first embodiment. Therefore, it may be seen that the calculation time for obtaining the same Pareto front was shortened. When the comparison is performed by using a hypervolume, the hypervolume was 1.3% lower in the method according to the first embodiment than in the method according to FIG. 2.

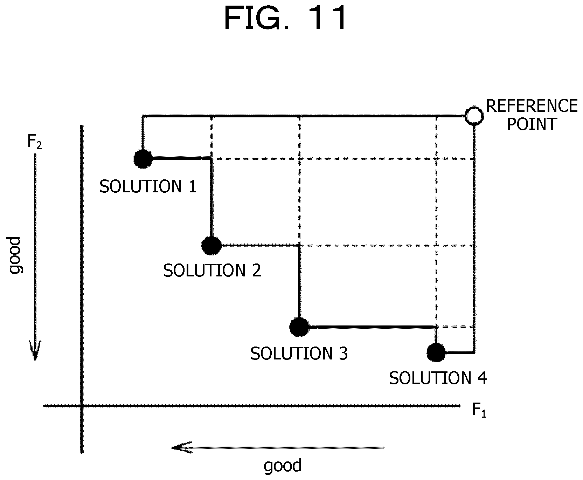

FIG. 11 is a diagram for describing the hypervolume. The hypervolume is a performance index for the Pareto solution. Specifically, the hypervolume represents an area or a volume of a region formed by a certain reference point and a solution set obtained by an algorithm in an objective function space. As an example, it is possible to use a standardized value of each objective function with the reference point of (0, 0). In a case where two objective functions are used, the area represented in FIG. 11 is the hypervolume. As the hypervolume is larger, the solution is wider, so that it may be determined that a favorable result is obtained.

(Simulation Results of Second Embodiment)

Next, simulation results of the second embodiment will be described. In the second embodiment, the objective function was set using a specific layout of a manufacturing field.

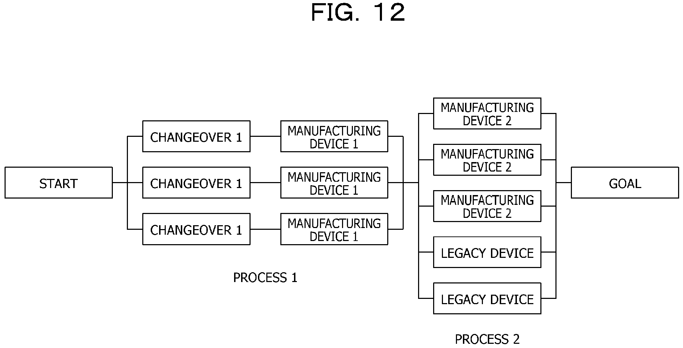

FIG. 12 is a diagram exemplifying a production line model. As exemplified in FIG. 12, the production line model contains branches and merges, and a plurality of products is input one by one. For each of the plurality of products, a plurality of works is performed in order. At least a part of the works are different for the plurality of products.

The production line model in FIG. 12 is a production line model including a process 1 and a process 2. When the process 1 and the process 2 are passed through in accordance with a product input order, branching and merging are repeated, and finally shipping is carried out through inspection and packaging processes. In the process 1, three manufacturing devices 1 with the same specifications are arranged. Before the work is performed in each manufacturing device 1, a changeover (work of changing setting of a jig or a device of a processing machine according to a type of a product to be produced) is performed.

In the process 2, no changeover is needed. In the process 2, three manufacturing devices 2 and two legacy devices with specifications different from those of the manufacturing devices 2 are arranged. The legacy device is a costly and time consuming device.

As an example, there are two changeover workers. Therefore, it is possible to simultaneously perform the changeover in at most two devices in parallel. A cost of each device increases in proportion to an operation time of the device.

With such a layout, as an example, a plan for optimizing a manufacturing time and a cost is made. For example, when it is attempted to shorten the manufacturing time by reducing the changeover, use of the legacy device increases and the cost increases, so that the manufacturing time and the cost are in a trade-off relationship.

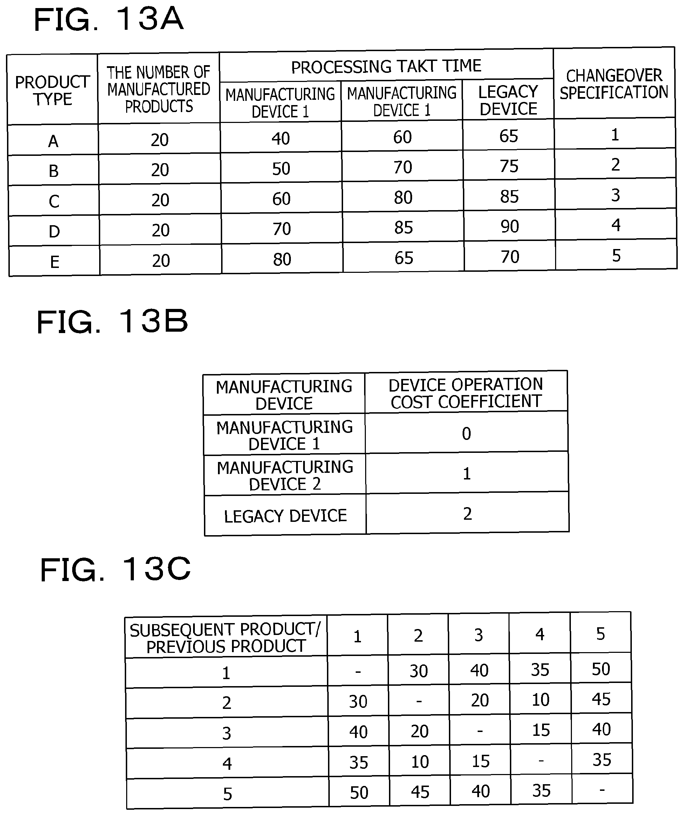

FIGs. 13(a) to 13(c) are diagrams exemplifying product information. FIG. 13(a) is a diagram exemplifying master information in a production master. FIG. 13(b) is a diagram exemplifying an operation cost in the production master. FIG. 13(c) is a diagram exemplifying a takt time of a changeover in the production master.

As exemplified in FIG. 13(a), the number of manufactured products, a processing takt time of the manufacturing device 1, a processing takt time of the manufacturing device 2, a processing takt time of the legacy device, and a changeover specification are associated with each of product types A to E. As exemplified in FIG. 13(b), a device operation cost coefficient is associated with each manufacturing device. The operation cost is calculated by multiplying the processing takt time by the coefficient. As exemplified in FIG. 13(c), a changeover takt time is associated with a combination of a subsequent product/a previous product. The previous product for a certain device is a type of a product for which a manufacturing process has been performed in the device so far. The subsequent product is a type of a product for which a manufacturing process is performed next in the device. A number of "subsequent product/previous product" is associated with a combination of the respective products.

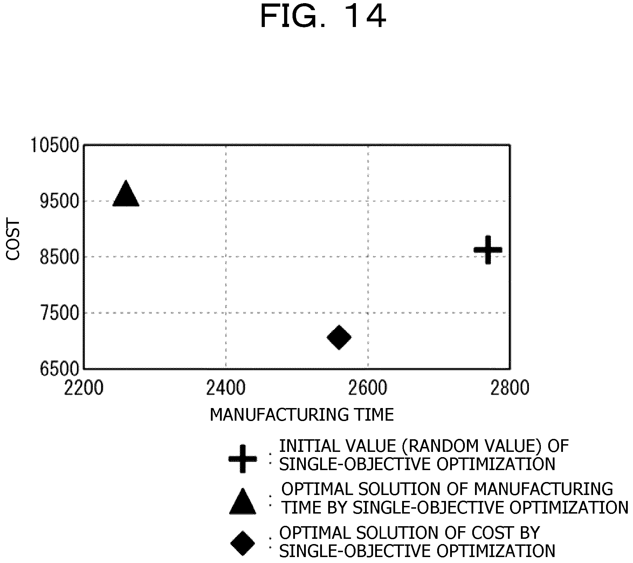

Two objective functions were set: the manufacturing time and the cost. It was assumed that a calculation time was extremely short by using a single-objective solving specialized engine capable of high-speed solving. A random value was set as an initial value. Results are indicated in FIG. 14. A horizontal axis indicates the manufacturing time, and a vertical axis indicates the cost. A single-objective optimal solution is obtained for each of manufacturing time and the cost.

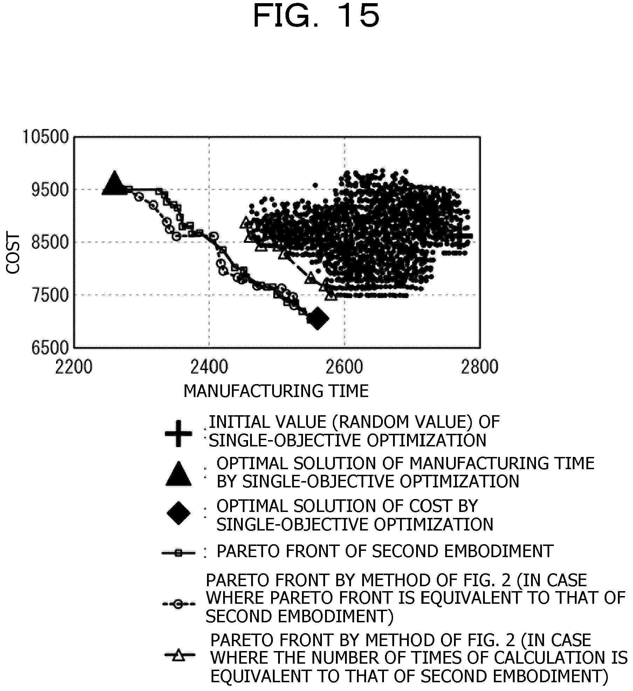

Next, the multi-objective optimization was performed with three objective functions of a linear weighted sum obtained by performing weighting in a direction perpendicular to a straight line coupling optimal solutions, the manufacturing time, and the cost using each single-objective optimal solution of the manufacturing time and the cost as a starting point. Results are indicated in FIG. 15. Since a result (HV = 0.576) equivalent to the Pareto front obtained by the method of the second embodiment (the number of times of calculation is about 600) may be obtained by the number of times of calculation of 1600 in the method of FIG. 2, it was possible to reduce a calculation amount by about 60%. Comparing the results of the method of FIG. 2 and the method of the second embodiment with the same number of times of calculation (about 600 times), a wider optimal Pareto front (HV is about twice) was calculated.

Note that, in each of the examples described above, the genetic algorithm is used as an optimization algorithm, but the present invention is not limited to this. Other optimization algorithms such as evolutionary algorithms may be used.

In each of the examples described above, the optimization execution unit 20 is an example of an execution unit that calculates single-objective optimal solutions that have better values than initial solutions by executing single-objective optimization by using each of a plurality of objective functions as a first evaluation function for the initial solutions, and executes, by using the single-objective optimal solutions as starting points, multiobjective optimization for a second evaluation function by using, as the second evaluation function, a linear weighted sum obtained by performing weighting for each of the plurality of objective functions according to the single-objective optimal solutions.

While the embodiments of the present invention have been described above in detail, the present invention is not limited to such specific embodiments, and a variety of modifications and alterations may be made within the scope of the gist of the present invention described in the claims.

All examples and conditional language provided herein are intended for the pedagogical purposes of aiding the reader in understanding the invention and the concepts contributed by the inventor to further the art, and are not to be construed as limitations to such specifically recited examples and conditions, nor does the organization of such examples in the specification relate to a showing of the superiority and inferiority of the invention. Although one or more embodiments of the present invention have been described in detail, it should be understood that the various changes, substitutions, and alterations could be made hereto without departing from the spirit and scope of the invention.

REFERENCE SIGNS LIST

10   Objective function setting unit

20   Optimization execution unit
30   Intermediate process recording unit
40   Result output unit
100   Information processing device
101   CPU
102   RAM

103     Storage device
104     Input device
105     Display device

**Claims**

1.  An arithmetic program for causing a computer to execute processing comprising:

    calculating single-objective optimal solutions that have better values than initial solutions by executing single-objective optimization by using each of a plurality of objective functions as a first evaluation function for the initial solutions; and
    executing, by using the single-objective optimal solutions as starting points, multi-objective optimization for a second evaluation function by using, as the second evaluation function, a linear weighted sum obtained by performing weighting for each of the plurality of objective functions according to the single-objective optimal solutions.

2.  The arithmetic program according to claim 1, wherein

    the number of the plurality of objective functions is two, and
    the computer is caused to execute processing of calculating an approximate straight line approximate to arrangement of the single-objective optimal solutions obtained by the execution of the single-objective optimization and solutions at an intermediate process, and setting the weighting in a direction that intersects the approximate straight line.

3.  The arithmetic program according to claim 2, wherein the direction that intersects the approximate straight line is a direction perpendicular to the approximate straight line.

4.  The arithmetic program according to claim 1, wherein

    the number of the plurality of objective functions is two, and
    the computer is caused to execute processing of setting the weighting in a direction that intersects a line that couples the single-objective optimal solutions obtained by the execution of the single-objective optimization.

5.  The arithmetic program according to claim 4, wherein the direction that intersects the line that couples the single-objective optimal solutions is a direction perpendicular to the line that couples the single-objective optimal solutions.

6.  The arithmetic program according to claim 1, wherein

    the number of the plurality of objective functions is three or more, and
    the computer is caused to execute processing of calculating an approximate plane approximate to arrangement of the single-objective optimal solutions obtained by the execution of the single-objective optimization and solutions at an intermediate process, and setting the weighting in a direction that intersects the approximate plane.

7.  The arithmetic program according to claim 6, wherein the direction that intersects the approximate plane is a direction perpendicular to the approximate plane.

8.  The arithmetic program according to claim 1, wherein

    the number of the plurality of objective functions is three or more, and
    the computer is caused to execute processing of setting the weighting in a direction that intersects a surface that couples the single-objective optimal solutions obtained by the execution of the single-objective optimization.

9.  The arithmetic program according to claim 8, wherein the direction that intersects the surface that couples the single-objective optimal solutions is a direction perpendicular to the surface that couples the single-objective optimal solutions.

10. An arithmetic method implemented by a computer, the arithmetic method comprising:

calculating single-objective optimal solutions that have better values than initial solutions by executing single-objective optimization by using each of a plurality of objective functions as a first evaluation function for the initial solutions; and

executing, by using the single-objective optimal solutions as starting points, multi-objective optimization for a second evaluation function by using, as the second evaluation function, a linear weighted sum obtained by performing weighting for each of the plurality of objective functions according to the single-objective optimal solutions.

11. The arithmetic method according to claim 10, wherein

the number of the plurality of objective functions is two, and

the computer is caused to execute processing of calculating an approximate straight line approximate to arrangement of the single-objective optimal solutions obtained by the execution of the single-objective optimization and solutions at an intermediate process, and setting the weighting in a direction that intersects the approximate straight line.

12. The arithmetic method according to claim 11, wherein the direction that intersects the approximate straight line is a direction perpendicular to the approximate straight line.

13. The arithmetic method according to claim 10, wherein

the number of the plurality of objective functions is two, and

the computer is caused to execute processing of setting the weighting in a direction that intersects a line that couples the single-objective optimal solutions obtained by the execution of the single-objective optimization.

14. The arithmetic method according to claim 13, wherein the direction that intersects the line that couples the single-objective optimal solutions is a direction perpendicular to the line that couples the single-objective optimal solutions.

15. The arithmetic method according to claim 10, wherein

the number of the plurality of objective functions is three or more, and

the computer is caused to execute processing of calculating an approximate plane approximate to arrangement of the single-objective optimal solutions obtained by the execution of the single-objective optimization and solutions at an intermediate process, and setting the weighting in a direction that intersects the approximate plane.

16. The arithmetic method according to claim 15, wherein the direction that intersects the approximate plane is a direction perpendicular to the approximate plane.

17. The arithmetic method according to claim 10, wherein

the number of the plurality of objective functions is three or more, and

the computer is caused to execute processing of setting the weighting in a direction that intersects a surface that couples the single-objective optimal solutions obtained by the execution of the single-objective optimization.

18. The arithmetic method according to claim 17, wherein the direction that intersects the surface that couples the single-objective optimal solutions is a direction perpendicular to the surface that couples the single-objective optimal solutions.

19. An information processing device comprising:

an execution unit configured to

calculate single-objective optimal solutions that have better values than initial solutions by executing single-objective optimization by using each of a plurality of objective functions as a first evaluation function for the initial solutions, and

execute, by using the single-objective optimal solutions as starting points, multi-objective optimization for a second evaluation function by using, as the second evaluation function, a linear weighted sum obtained by performing weighting for each of the plurality of objective functions according to the single-objective optimal solutions.

20. The information processing device according to claim 19, wherein

the number of the plurality of objective functions is two, and
the execution unit calculates an approximate straight line approximate to arrangement of the single-objective optimal solutions obtained by the execution of the single-objective optimization and solutions at an intermediate process, and sets the weighting in a direction that intersects the approximate straight line.

21. The information processing device according to claim 20, wherein
the direction that intersects the approximate straight line is a direction perpendicular to the approximate straight line.

22. The information processing device according to claim 19, wherein

the number of the plurality of objective functions is two, and
the execution unit sets the weighting in a direction that intersects a line that couples the single-objective optimal solutions obtained by the execution of the single-objective optimization.

23. The information processing device according to claim 22, wherein
the direction that intersects the line that couples the single-objective optimal solutions is a direction perpendicular to the line that couples the single-objective optimal solutions.

24. The information processing device according to claim 19, wherein

the number of the plurality of objective functions is three or more, and
the execution unit calculates an approximate plane approximate to arrangement of the single-objective optimal solutions obtained by the execution of the single-objective optimization and solutions at an intermediate process, and sets the weighting in a direction that intersects the approximate plane.

25. The information processing device according to claim 24, wherein
the direction that intersects the approximate plane is a direction perpendicular to the approximate plane.

26. The information processing device according to claim 25, wherein

the number of the plurality of objective functions is three or more, and
the execution unit sets the weighting in a direction that intersects a surface that couples the single-objective optimal solutions obtained by the execution of the single-objective optimization.

27. The information processing device according to claim 26, wherein
the direction that intersects the surface that couples the single-objective optimal solutions is a direction perpendicular to the surface that couples the single-objective optimal solutions.

# FIG. 1

# FIG. 2

# FIG. 3

SEARCH DIRECTIONS
OF OPTIMAL SOLUTION

━━━ : PARETO FRONT

INITIAL SOLUTIONS

$f_1(x_1) \cdot w + f_2(x_1) \cdot (1-w)$

$f_1(x_2) \cdot w + f_2(x_2) \cdot (1-w)$

$f_1(x_3) \cdot w + f_2(x_3) \cdot (1-w)$

OBJECTIVE FUNCTION f2

MINIMIZE

OBJECTIVE FUNCTION $f_1$

MINIMIZE

# FIG. 4A

100

10

OBJECTIVE FUNCTION
SETTING UNIT

20

OPTIMIZATION
EXECUTION UNIT

30

INTERMEDIATE PROCESS
RECORDING UNIT

40

RESULT OUTPUT UNIT

# FIG. 4B

101

CPU

102

RAM

STORAGE
DEVICE

103

INPUT DEVICE

104

DISPLAY
DEVICE

105

# FIG. 5

START

SET N OBJECTIVE FUNCTIONS ($f_n$; n = 1 TO N) DESIRED TO BE OPTIMIZED — S1

n=1 — S2

SET INITIAL VALUE OF EXPLANATORY VARIABLE WITH RANDOM VALUE — S3

CALCULATE VALUES OF OBJECTIVE FUNCTIONS $f_1$ TO $f_N$ ACCORDING TO EXPLANATORY VARIABLE — S4

UPDATE EXPLANATORY VARIABLE SO THAT EVALUATION FUNCTION IS OPTIMIZED BY SINGLE-OBJECTIVE OPTIMIZATION ENGINE — S7

RECORD EXPLANATORY VARIABLE AND VALUES OF OBJECTIVE FUNCTIONS $f_1$ TO $f_N$ — S5

HAS OPTIMAL SOLUTION OF OBJECTIVE FUNCTION $f_n$ CONVERGED? — S6
NO

YES

n ≥ N? — S8
NO

n=n+1 — S9

YES

EXTRACT PARETO SOLUTIONS FROM ALL CALCULATION RESULTS — S10

CALCULATE WEIGHTED AVERAGE SUM OBTAINED BY PERFORMING WEIGHTING IN DIRECTION PERPENDICULAR TO APPROXIMATE STRAIGHT LINE OF PARETO FRONT — S11

EXECUTE MULTI-OBJECTIVE OPTIMIZATION USING OBJECTIVE FUNCTIONS $f_1$ TO $f_N$ AND LINEAR WEIGHTED SUM AS EVALUATION FUNCTIONS — S12

CALCULATE PARETO SOLUTIONS — S13

END

## FIG. 6A

## FIG. 6B

# FIG. 7

START

SET N OBJECTIVE FUNCTIONS ($f_n$; n = 1 TO N) DESIRED TO BE OPTIMIZED — S21

n=1 — S22

SET INITIAL VALUE OF EXPLANATORY VARIABLE WITH RANDOM VALUE — S23

CALCULATE VALUES OF OBJECTIVE FUNCTIONS $f_1$ TO $f_N$ ACCORDING TO EXPLANATORY VARIABLE — S24

UPDATE EXPLANATORY VARIABLE SO THAT EVALUATION FUNCTION IS OPTIMIZED BY SINGLE-OBJECTIVE OPTIMIZATION ENGINE — S26

HAS OPTIMAL SOLUTION OF OBJECTIVE FUNCTION $f_n$ CONVERGED? — S25 — NO

YES — S27

n ≥ N? — NO

n=n+1 — S28

YES

EXTRACT OPTIMAL SOLUTION FOR EACH OBJECTIVE FUNCTION — S29

CALCULATE WEIGHTED AVERAGE SUM OBTAINED BY PERFORMING WEIGHTING IN DIRECTION PERPENDICULAR TO STRAIGHT LINE COUPLING OPTIMAL SOLUTIONS — S30

EXECUTE MULTI-OBJECTIVE OPTIMIZATION USING OBJECTIVE FUNCTIONS $f_1$ TO $f_N$ AND LINEAR WEIGHTED SUM AS EVALUATION FUNCTIONS — S31

CALCULATE PARETO SOLUTIONS — S32

END

## FIG. 8A

## FIG. 8B

# FIG. 9

● : ALL CALCULATION RESULTS OF SINGLE-OBJECTIVE OPTIMIZATION OF $f_1[x]$
○ : ALL CALCULATION RESULTS OF SINGLE-OBJECTIVE OPTIMIZATION OF $f_2[x]$
⊟ : PARETO FRONT OF SINGLE-OBJECTIVE OPTIMIZATION RESULTS OF $f_1[x]$
   AND $f_2[x]$

# FIG. 10

─▣─ : INITIAL SOLUTION (PARETO FRONT OF $f_1$ AND $f_2$)
● : PARETO SOLUTION OF FIRST EMBODIMENT
○ : PARETO SOLUTION BY METHOD OF FIG. 2

# FIG. 11

# FIG. 12

```
                    ┌──────────────┐   ┌──────────────┐              ┌──────────────┐
                    │ CHANGEOVER 1 │   │ MANUFACTURING│              │ MANUFACTURING│
                    │              │   │   DEVICE 1   │              │   DEVICE 2   │
                    └──────────────┘   └──────────────┘              └──────────────┘
┌──────────┐        ┌──────────────┐   ┌──────────────┐              ┌──────────────┐        ┌──────────┐
│  START   │        │ CHANGEOVER 1 │   │ MANUFACTURING│              │ MANUFACTURING│        │   GOAL   │
│          │        │              │   │   DEVICE 1   │              │   DEVICE 2   │        │          │
└──────────┘        └──────────────┘   └──────────────┘              └──────────────┘        └──────────┘
                    ┌──────────────┐   ┌──────────────┐              ┌──────────────┐
                    │ CHANGEOVER 1 │   │ MANUFACTURING│              │ MANUFACTURING│
                    │              │   │   DEVICE 1   │              │   DEVICE 2   │
                    └──────────────┘   └──────────────┘              └──────────────┘
                                                                     ┌──────────────┐
                           PROCESS 1                                 │ LEGACY DEVICE│
                                                                     └──────────────┘
                                                                     ┌──────────────┐
                                                                     │ LEGACY DEVICE│
                                                                     └──────────────┘

                                                                          PROCESS 2
```

## FIG. 13A

| PRODUCT TYPE | THE NUMBER OF MANUFACTURED PRODUCTS | PROCESSING TAKT TIME | | | CHANGEOVER SPECIFICATION |
|---|---|---|---|---|---|
| | | MANUFACTURING DEVICE 1 | MANUFACTURING DEVICE 1 | LEGACY DEVICE | |
| A | 20 | 40 | 60 | 65 | 1 |
| B | 20 | 50 | 70 | 75 | 2 |
| C | 20 | 60 | 80 | 85 | 3 |
| D | 20 | 70 | 85 | 90 | 4 |
| E | 20 | 80 | 65 | 70 | 5 |

## FIG. 13B

| MANUFACTURING DEVICE | DEVICE OPERATION COST COEFFICIENT |
|---|---|
| MANUFACTURING DEVICE 1 | 0 |
| MANUFACTURING DEVICE 2 | 1 |
| LEGACY DEVICE | 2 |

## FIG. 13C

| SUBSEQUENT PRODUCT/ PREVIOUS PRODUCT | 1 | 2 | 3 | 4 | 5 |
|---|---|---|---|---|---|
| 1 | - | 30 | 40 | 35 | 50 |
| 2 | 30 | - | 20 | 10 | 45 |
| 3 | 40 | 20 | - | 15 | 40 |
| 4 | 35 | 10 | 15 | - | 35 |
| 5 | 50 | 45 | 40 | 35 | - |

# FIG. 14

Legend:
+ : INITIAL VALUE (RANDOM VALUE) OF SINGLE-OBJECTIVE OPTIMIZATION
▲ : OPTIMAL SOLUTION OF MANUFACTURING TIME BY SINGLE-OBJECTIVE OPTIMIZATION
◆ : OPTIMAL SOLUTION OF COST BY SINGLE-OBJECTIVE OPTIMIZATION

# FIG. 15

+ : INITIAL VALUE (RANDOM VALUE) OF SINGLE-OBJECTIVE OPTIMIZATION

▲ : OPTIMAL SOLUTION OF MANUFACTURING TIME BY SINGLE-OBJECTIVE OPTIMIZATION

◆ : OPTIMAL SOLUTION OF COST BY SINGLE-OBJECTIVE OPTIMIZATION

—▫— : PARETO FRONT OF SECOND EMBODIMENT

--◎-- : PARETO FRONT BY METHOD OF FIG. 2 (IN CASE WHERE PARETO FRONT IS EQUIVALENT TO THAT OF SECOND EMBODIMENT)

—△— : PARETO FRONT BY METHOD OF FIG. 2 (IN CASE WHERE THE NUMBER OF TIMES OF CALCULATION IS EQUIVALENT TO THAT OF SECOND EMBODIMENT)

## INTERNATIONAL SEARCH REPORT

| International application No. |
| --- |
| **PCT/JP2022/032329** |

**A. CLASSIFICATION OF SUBJECT MATTER**

*G06Q 10/0639*(2023.01)i; *G16Z 99/00*(2019.01)i
FI:    G06Q10/06 332; G16Z99/00

According to International Patent Classification (IPC) or to both national classification and IPC

**B. FIELDS SEARCHED**

Minimum documentation searched (classification system followed by classification symbols)

G06Q10/00-99/00; G16Z99/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | 渡邉 真也 WATANABE, Shinya. 单目的最適化問題における多目的化とその有効性 Multiobjective Approaches in Single Objective Optimization Environment. 情報処理学会論文誌 vol. 46 no. SIG17 (TOM13) IPSJ. 19 December 2005 (accession date) chapter 4, fig. 1-2 | 1, 10, 19 |
| A | | 2-9, 11-18, 20-27 |
| A | JP 2009-169557 A (FUJITSU LTD) 30 July 2009 (2009-07-30) entire text, all drawings | 1-27 |
| A | WO 2021/186551 A1 (FUJITSU LTD) 23 September 2021 (2021-09-23) entire text, all drawings | 1-27 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **02 November 2022** | **15 November 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/032329**

| Patent document cited in search report | | | Publication date (day/month/year) | Patent family member(s) | | | Publication date (day/month/year) |
|---|---|---|---|---|---|---|---|
| JP | 2009-169557 | A | 30 July 2009 | US | 2009/0182539 | A1 | |
| | | | | CN | 101493854 | A | |
| | | | | KR 10-2009-0078303 | | A | |
| WO | 2021/186551 | A1 | 23 September 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022083200 A
- JP 2002366587 A
- US 20150019173 A
- US 20160306899 A

**Non-patent literature cited in the description**

- **ECKART ZITZLER** ; **KALYANMOY DED** ; **LOTHAR THIELE**. Comparison of Multiobjective Evolutionary Algorithms: Empirical Results. *Evolutionary Computation*, 2000, vol. 8 (2), 173-195